# EUROPEAN PATENT APPLICATION

(11) **EP 2 712 946 A1**
(43) Date of publication of application: **02.04.2014**
(21) Application number: 13791676.3
(22) Date of filing: 19.02.2013
(51) Int. Cl.: C30B 29/06, C03B 20/00, C30B 15/10

(54) **SILICA VESSEL FOR DRAWING UP MONOCRYSTALLINE SILICON AND METHOD FOR PRODUCING SAME**

(30) Priority: 15.05.2012 JP 2012111903
(71) Applicant: Shin-Etsu Quartz Products Co., Ltd., Shinjuku-ku Tokyo 160-0023 (JP)
(72) Inventor: YAMAGATA, Shigeru, Tokyo 160-0023 (JP)
(74) Representative: Wibbelmann, Jobst
(86) International application number: PCT/JP2013/000890
(87) International publication number: WO 2013/171937

(57) **Abstract**

The present invention provides a single-crystal silicon pulling silica container comprising: a transparent layer made of transparent silica glass in the inner side of the silica container; and an opaque layer made of opaque silica glass containing gaseous bubbles in the outer side of the silica container, wherein the transparent layer is constituted of a high-OH group layer that is placed on an inner surface side of the silica container and contains the OH group at a concentration of 200 to 2000 ppm by mass and a low-OH group layer that has the OH group concentration lower than that of the high-OH group layer, and the high-OH group layer contains Ba at a concentration of 50 to 2000 ppm by mass. As a result, in a case where the silica container is used for pulling single-crystal silicon, there can be provided the silica container that can greatly improve etching resistance (corrosion resistance) of the container inner surface to silicon melt when the entire inner surface made of transparent silica glass of the container is finely crystallized (turned to glass ceramics) in a short time after start of using the container and also provided a method for producing such a silica container.

## Description

### TECHNICAL FIELD

The present invention relates to a silica container for pulling single-crystal silicon and a producing method thereof.

### BACKGROUND ART

Silica glass is used for a lens, a prism, and a photomask in a projection aligner (a lithography apparatus) for manufacturing large-scale integration (LSI), a display TFT substrate, an ultraviolet lamp tube, a window material, a reflector, a semiconductor industrial cleaning container, a silicon melt container, and others. However, as a raw material of the silica glass, a compound such as expensive silicon tetrachloride must be used, and a silica glass melting temperature or processing temperature is as considerably high as approximately 2000°C, energy consumption is hence high, and a cost rises. Therefore, a silica glass producing method using a relatively inexpensive natural powdery raw material has been conventionally considered.

Even now, as a method for producing a silica crucible for single-crystal silicon manufacture for devices like LSI, such producing methods as described in Patent Literatures 1 and Patent Literature 2 are used. Each of these methods is a method for putting a quartz powder or a rock crystal powder subjected to an ultra-high purity treatment into a rotating carbon mold, performing molding, then pushing carbon electrodes from above, applying a voltage to the carbon electrodes to cause arc discharge, and increasing an atmospheric temperature to a melting temperature zone (which is assumed to be approximately 1800 to 2100°C) of the quartz powder, thereby melting and sintering the quartz powder. However, these producing methods have problems in production cost and single-crystal silicon quality. For example, the methods are high costs because the high-purity quartz raw material powder is used; occurrence of gas release at the time of using the crucible because various kinds of impurity gases are dissolved in the produced silica crucible; and the released gases form cavity defects called voids or pinholes in the single-crystal silicon. Further, the inner wall of the crucible is apt to be dissolved because its etching resistance to the silicon melt is low, and thus a serious problem occurs in durability of the silica crucible.

A method for improving the etching resistance to silicon melt of the single-crystal silicon pulling silica crucible is disclosed in Patent Literature 3, and this literature shows an effect of applying or dissolving a crystallization accelerator to or in an inner surface of a silica glass crucible. As the crystallization accelerator, alkaline-earth metal elements Mg, Sr, Ca, and Ba as 2a group elements or Al as a 3b group element are presented. However, in the silica glass crucible described in this literature, because a crucible inner surface is not uniformly recrystallized during pulling single-crystal silicon, etching of the inner sidewall of the crucible by silicon melt is not sufficiently lowered, and durability of the silica crucible is not improved.

Furthermore, Patent Literature 4 discloses technology that reduces emission of crystalline silica particles from a silica crucible inner surface into the silicon melt or technology that strengthens the silica crucible from an outer surface of the silica crucible. As a technique for these technologies, allowing a devitrification accelerator to be present on the surface or the crucible, which is specifically allowing an alkaline earth metal selected from a group including Ba, Mg, Sr, and Be to be included is disclosed. However, in such a silica crucible, the crucible surface is not rapidly recrystallized at the start of pulling the single-crystal silicon, or the entire surface is not uniformly recrystallized, etching of the silica crucible inner surface using the silicon melt is not sufficiently reduced, and durability of the silica crucible is not improved.

As another technique for recrystallizing an inner surface of a silica crucible, Patent Literature 5 discloses that, when the OH group concentration near the surface is set to 115 ppm or more while sloping the OH group concentration at a surface depth of 0.3 to 3 mm, the surface portion can be readily recrystallized without using a crystallization accelerator. However, according to such technology, because an etching amount of the surface portion by the silicon melt is considerably large, there occurs a problem that the surface layer is dissolved when melting blocks of polysilicon raw material in the silica crucible, and the silica crucible inner surface is not uniformly recrystallized at the time of subsequent pulling of the single-crystal silicon.

Patent Literature 6 discloses a silica container obtained by a sol-gel method at low cost and a producing method thereof. An outer layer of the silica container is a white opaque layer, and an inner layer of the same is a transparent silica glass layer containing carbon. In an example, a transparent silica glass layer with a thickness of 3 mm containing Ba and the OH group is described. Although a certain level of a recrystallization acceleration effect can be recognized in such a silica glass container at the time of using this container, uniform recrystallization on the entire inner surface of the container at start of using the container is further demanded.

Patent Literature 7 discloses a silica container produced by preparing a silica raw material powder doped with crystallization accelerators Ca, Sr, and Ba and a hydrogen gas in advance and discharging, heating, and melting this raw material powder. Although a certain level of a recrystallization acceleration effect in the container can be recognized in this silica container at the time of pulling the single-crystal silicon, uniformly recrystallizing the entire surface of the container inner surface at an early stage is insufficient.

Moreover, as technology similar to that in Patent Literature 7, Patent Literature 8 discloses a silica container produced by performing arc discharge heating with respect to a silica raw material powder containing crystallization accelerators Ca, Sr, and Ba in a hydrogen containing gas atmosphere. Although a certain level of recrystallization effect on a container inner surface at the time of pulling single-crystal silicon is likewise recognized in such a container, uniformly recrystallizing the entire container inner surface at an early stage of using the crucible is insufficient.

Patent Literature 9 and Patent Literature 10 disclose that a thickness is increased by devising a shape of an outer wall of a silica crucible as a countermeasure for corrosion (etching) of the silica crucible by the silicon melt. However, since this method does not fundamentally reduce the corrosion (etching) of a silica crucible main body by the silicon melt, oxygen concentration in the silicon melt due to melting of silica glass is greatly increased, impurity metal elements contained in the silica crucible are contaminated, or quality of pulled single crystal silicon becomes poor.

### CITATION LIST

### PATENT LITERATURES

Patent Literature 1: Japanese Examined Patent Application Publication No. H4-22861
Patent Literature 2: Japanese Examined Patent Application Publication No. H7-29871
Patent Literature 3: Japanese Patent No. 3100836
Patent Literature 4: Japanese Patent No. 3046545
Patent Literature 5: International Publication No. WO 2009/113525
Patent Literature 6: Japanese Unexamined Patent Application Publication No. 2010-189205
Patent Literature 7: Japanese Unexamined Patent Application Publication No. 2011-84428
Patent Literature 8: Japanese Unexamined Patent Application Publication No. 2011-121811
Patent Literature 9: Japanese Unexamined Patent Application Publication No. 2011-121842
Patent Literature 10: Japanese Unexamined Patent Application Publication No. 2011-121843

### SUMMARY OF INVENTION

### TECHNICAL PROBLEM

In view of the above-described problems, it is an object of the present invention to provide a silica container that greatly improves etching resistance (corrosion resistance) of a container inner surface to the silicon melt when the entire inner surface made of transparent silica glass of the container is finely crystallized (turned to glass ceramics) within a short time after start of using the container in a case that the silica container is used for pulling single-crystal silicon, and to provide a method for producing such a silica container.

### SOLUTION TO PROBLEM

According to the present invention, to solve the above-described problems, there is provided a single-crystal silicon pulling silica container comprising: a transparent layer made of transparent silica glass in an inner side of the silica container, and an opaque layer made of opaque silica glass containing gaseous bubbles in an outer side of the silica container, wherein the transparent layer is constituted of a high-OH group layer that is placed in an inner surface side of the silica container and contains the OH group at a concentration of 200 to 2000 ppm by mass and a low-OH group layer that has the OH group concentration lower than that of the high-OH group layer, and the high-OH group layer contains Ba at a concentration of 50 to 2000 ppm by mass.

According to the above-described silica container having the layer (the high-OH group layer) that contains both the OH group and Ba at high concentrations in the inner surface side of the transparent layer, when this container is used for pulling single-crystal silicon, the entire inner surface of the high-OH group layer can be finely crystallized (turned to glass ceramics) within a short time after start of using the container. Therefore, etching resistance (corrosion resistance) of the inner surface of the silica container to the silicon melt can be greatly improved.

In this case, it is preferable for a thickness of the high-OH group layer to be 0.5 mm or more and 3 mm or less.

When the high-OH group layer containing Ba has such a thickness, the etching resistance of the transparent layer can be sufficiently obtained.

Moreover, it is preferable for the high-OH group layer to contain Ba at a concentration of 100 to 1000 ppm by mass and contain the OH group at a concentration of 300 to 1500 ppm by mass.

When each of Ba and the OH group in the high-OH group layer is set to such concentration, the etching resistance at the time of using the silica container can be more effectively provided.

Additionally, according to the present invention, there is provided a method for producing a single-crystal silicon pulling silica container, comprising the steps of: preparing a silica powder having a particle size of 10 to 1000 µm as a first raw material powder; preparing a silica powder that contains Ba at a concentration of 50 to 2000 ppm by mass and has a particle size of 10 to 1000 µm, as a second raw material powder; putting the first raw material powder into a mold, temporarily molding the first raw material powder into a predetermined shape associated with an inner wall of the mold while rotating the mold, and thereby forming a temporary compact; heating and melting the temporary compact by a discharge heating melting method while rotating the temporary compact in the mold, and thereby obtaining a silica substrate that comprises a first transparent layer made of transparent silica glass in an inner side of the silica substrate and an opaque layer made of opaque silica glass containing gaseous bubbles in an outer side of the silica substrate; providing a water vapor containing gas atmosphere on the inner side of the silica substrate, performing heating and melting based on a discharge heating melting method while spreading the second raw material powder on the inner side of the silica substrate, forming on the first transparent layer a second transparent layer made of transparent silica glass containing Ba and the OH group at higher concentrations than those of the first transparent layer, and thereby fabricating a silica container having a transparent layer constituted of the first transparent layer and the second transparent layer in an inner side of the silica container and an opaque layer in an outer side of the silica container; and cooling the fabricated silica container to a room temperature, wherein the OH group concentration is 200 to 2000 ppm by mass in a region on at least an inner surface side of the second transparent layer.

According to such a method, it is possible to produce the silica container having the layer that contains both the OH group and Ba at high concentration on the inner surface side of the transparent layer at low cost. As described above, such a silica container enables finely crystallizing the entire inner surface side of the transparent layer within a short time after start of using the container when the silica container is used for pulling the single-crystal silicon, thus greatly improving the etching resistance to the silicon melt.

In this case, it is preferable to provide, at the step of cooling, the water vapor containing gas atmosphere in the silica container until a temperature is lowered to at least 200°C or less.

As described above, when the water vapor containing gas atmosphere is adopted as the atmosphere at the step of cooling, a fluctuation in the OH group concentration in the cooling step can be controlled.

Further, in a method for producing a single-crystal silicon pulling silica container according to the present invention, the step of heating and melting the temporary compact can be carried out while degassing a gas component contained the temporary compact by reducing a pressure from the outside of the temporary compact.

As described above, when the step of heating and melting the temporary compact is carried out while reducing a pressure, thicknesses or the like of the opaque layer and the first transparent layer can be more precisely controlled, thus forming a silica substrate.

### ADVANTAGEOUS EFFECTS OF INVENTION

When the single-crystal silicon pulling silica container according to the present invention is used for pulling single-crystal silicon, since the entire inner surface of the high-OH group layer can be finely crystallized in a short time after start of using the container, the etching resistance of the silica container inner surface to the silicon melt can be greatly improved. Further, the method for producing a single-crystal silicon pulling silica container according to the present invention enables producing such a silica container at a low cost.

### BRIEF DESCRIPTION OF DRAWINGS

FIG. 1 is a schematic cross-sectional view schematically showing an example of a configuration of a silica container according to the present invention;
FIG. 2 is an enlarged cross-sectional view schematically showing an example of the configuration of the silica container according to the present invention;
FIG. 3 is a flowchart showing an outline of an example of a method for producing a silica container according to the present invention;
FIG. 4 is a schematic cross-sectional view showing an example of a mold that can be used in the method for producing a silica container according to the present invention;
FIG. 5 is a schematic cross-sectional view showing another example of the mold that can be used in the method for producing a silica container according to the present invention;
FIG. 6 is a schematic cross-sectional view schematically showing an example of a step of forming a temporary compact in the method for producing a silica container according to the present invention;
FIG. 7 is a schematic cross-sectional view schematically showing part (before discharge heating melting) of an example of a step of heating the temporary compact in the method for producing a silica container according to the present invention;
FIG. 8 is a schematic cross-sectional view schematically showing part (during discharge heating melting) of the example of the step of heating the temporary compact in the method for producing a silica container according to the present invention; and
FIG. 9 is a schematic cross-sectional view schematically showing an example of a step of forming a second transparent layer in the method for producing a silica container according to the present invention.

### DESCRIPTION OF EMBODIMENTS

As described above, the problem to be solved by the present invention is to greatly improve etching resistance (corrosion resistance) of an inner surface of a silica container to silicon melt by finely crystallizing (turning to glass ceramics) an entire inner surface of a colorless and transparent silica glass of the container to form crystals such as cristobalite in a short time after start of using the silica container in case of using the silica container for pulling single-crystal silicon.

An improvement in etching resistance of an inner surface of a single-crystal silicon pulling silica container leads to excellent results. For example, although small cavity defects called voids or pinholes may be sometimes generated in single-crystal silicon to be produced, one of causes is assumed to be a silicon monoxide (SiO) gas reacted and generated by etching a silica container surface with silicon melt, and improving the etching resistance enables reducing these cavity defects. Further, likewise, as a cause of inhibition of growth of the single-crystal silicon and generation of dislocations, there is occurrence of foreign particle defects consisting of silica fine particles, and one factor is assumed to be silica (SiO₂) particles detached when the surface is roughened by etching of the silica container surface with the silicon melt. Furthermore, when an etching amount of the silica container inner surface is increased, oxygen concentration in the silicon melt rises. Therefore, the improvement in etching resistance contributes to an improvement in single-crystal silicon quality.

In case of using the silica container at a high temperature, impurities contained in the silica container, e.g., alkali metal elements Li, Na, and K, transition metal elements Ti, Cr, Mn, Fe, Ni, Cu, Zn, Zr, Mo, and W, and others are diffused and eluted into the silicon melt. The recrystallized silica container surface also has a shield effect for reducing diffusion of these impurity elements into the silicon melt.

Although one silica container is used for pulling one silicon single crystal in conventional examples, pulling a plurality of silicon single crystals (multi-pulling) with use of one container has been demanded in terms of a reduction in cost in recent years. As described above, improving the etching resistance of the silica container enables reducing defects, e.g., voids, pinholes, or foreign particles, suppressing an increase in oxygen concentration, and avoiding impurity contamination, whereby multi-pulling of high-quality single crystal silicon (for, e.g., large-scale integration (for LSI) or solar use (for photovoltaic generation or for PV)) can be carried out.

A single-crystal silicon pulling silica container and a producing method thereof according to the present invention will now be described hereinafter in detail with reference to the drawings, but the present invention is not restricted thereto.

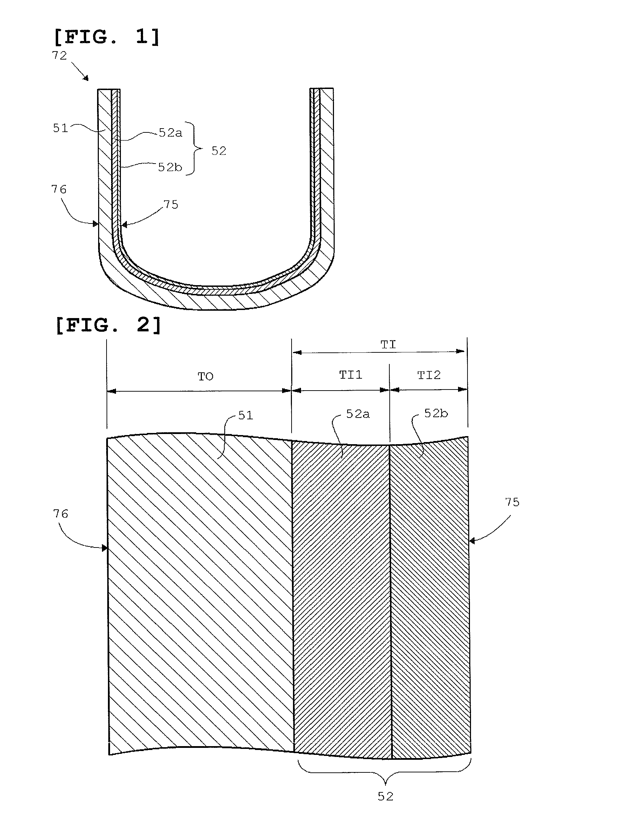

A single-crystal silicon pulling silica container according to the present invention will now be described with reference to FIG. 1 and FIG. 2.

As shown in FIG. 1, a single-crystal silicon pulling silica container 72 according to the present invention has a transparent layer 52 made of transparent silica glass in the inner side and an opaque layer 51 that contains gaseous bubbles and is made of opaque silica glass in the outer side. The transparent layer 52 does not substantially contain gaseous bubbles. It is to be noted that the opaque layer 51 is usually white opaque, and the transparent layer 52 is usually colorless and transparent. In the present invention, the transparent layer 52 further comprises a low-OH group layer 52a placed on the opaque layer 51 side (i.e., an outer surface 76 side of the silica container) of the silica container 72 and a high-OH group layer 52b placed on an inner surface 75 side of the silica container 72. The high-OH group layer 52b contains the OH group at a concentration of 200 to 2000 ppm by mass. The low-OH group layer 52a has a lower OH group concentration than that in the high-OH group layer 52b. In the present invention, the high-OH group layer 52b contains Ba at a concentration of 50 to 2000 ppm by mass. The high-OH group layer 52b has the OH group concentration and the Ba concentration meeting the above-described numerical ranges within an overall range of a thickness thereof.

FIG. 2 is an enlarged schematic cross-sectional view showing a cross section of a sidewall portion of the silica container 72 according to the present invention. In FIG. 2, "TO" represents a thickness of the opaque layer 51 and "TI" represents a thickness of the transparent layer 52, respectively. Further, "TI1" represents a thickness of the low-OH group layer 52a and "TI2" represents a thickness of the high-OH group layer 52b, respectively. That is, TI=TI1+TI2 is achieved.

It is known that Ba has a crystallization accelerating effect of crystallizing silica glass into cristobalite or the like at a high temperature when it is contained in the silica glass. Further, the OH group has an effect of enhancing the crystallization accelerating effect of Ba. However, since the OH group also has an effect of reducing viscosity of the silica glass at a high temperature or degrading etching resistance to silicon melt, there is a preferred concentration range. As described above, in the inner layer (the high-OH group layer 52b) of the transparent layer 52 made of transparent silica glass, when the OH group concentration is set to 200 to 2000 ppm by mass and the Ba concentration is set to 50 to 2000 ppm by mass, the entire inner surface of the silica container can turn to a uniform and precise white opaque recrystallized layer in a short time at a high temperature (approximately 1300 to 1600°C) at the time of using the silica container for pulling the single-crystal silicon.

Furthermore, in the silica container 72 according to the present invention, to prevent the viscosity and the etching resistance of the transparent layer 52 from lowering, the low-OH group layer 52a must be present in the transparent layer 52. That is, in the silica container 72 according to the present invention, the range that both the OH group and Ba are contained in the above-described range is restricted to a region near the inner surface of the transparent layer 52. It is preferable for the high-OH group layer 52b to contain Ba at a concentration of 100 to 1000 ppm by mass and contain the OH group at a concentration of 300 to 1500 ppm by mass.

The thickness TI2 of the high-OH group layer 52b shown in FIG. 2 is preferably 0.5 mm or more and 3 mm or less. When the high-OH group layer 52b has a thickness of 0.5 mm or more, the etching resistance of the surface the transparent layer 52 can be sufficiently obtained. When the high-OH group layer 52b has a thickness of 3 mm or less, the viscosity and the etching resistance can be sufficiently maintained. It is more preferable to set the thickness of the high-OH group layer 52b to 1 mm or less.

The above-described silica container 72 can be produced as follows. A method for producing a single-crystal silicon pulling silica container according to the present invention will now be more specifically explained.

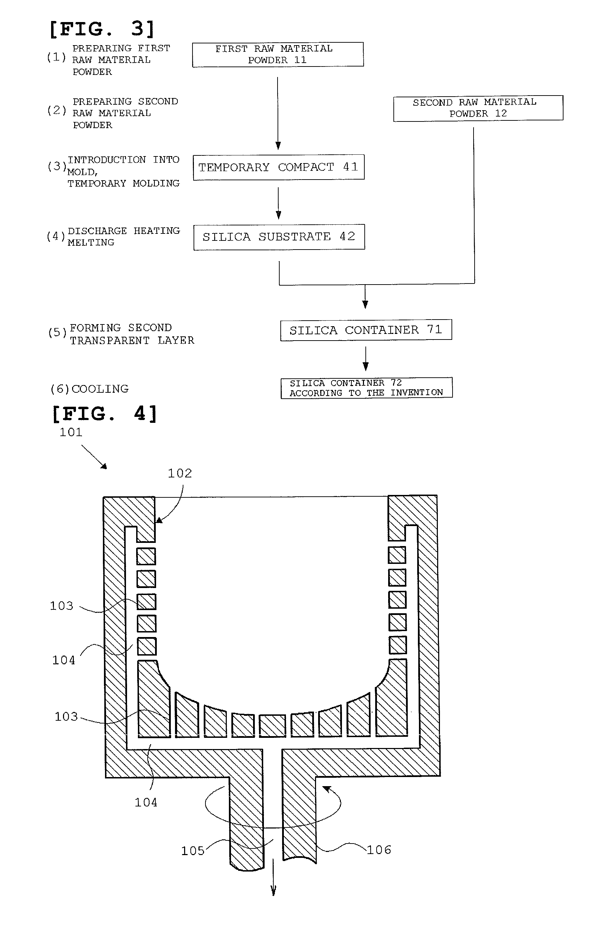

A method for producing the silica container 72 shown in FIG. 1 will now be described with reference to FIG. 3.

First, as shown in (1) of FIG. 3, a silica powder having a particle size of 10 to 1000 µm is prepared as a first raw material powder 11.

Although this first raw material powder 11 can be prepared by, e.g., pulverizing and sizing blocks of silica as follows, the present invention is not restricted thereto.

First, a block of natural silica (rock crystal, quartz, silica, siliceous stones, opal stones, and others which are naturally yielded) having a diameter of approximately 5 to 50 mm is heated in an air atmosphere in a temperature region of 600 to 1000°C for approximately 1 to 10 hours. Then, the block of natural silica is put into water, rapidly cooled, then taken out, and dried. This treatment can facilitate a subsequent treatment of pulverization and sizing using a crusher or the like, but the processing may advance to a pulverization treatment without performing this heating and rapid cooling treatment.

Subsequently, the block of natural silica is pulverized and sized with use of a crusher or the like, and its particle size is preferably adjusted to 10 to 1000 µm or more preferably 50 to 500 µm, thereby obtaining a natural silica powder.

Then, this natural silica powder is put into a rotary kiln constituted of a silica glass tube having an inclined angle, a hydrogen chloride (HCl) or chlorine (Cl₂) gas containing atmosphere is provided in the kiln, and a purification treatment is carried out by performing heating at 800 to 1100°C for approximately 1 to 10 hours. However, in a product use application that does not require high purity, the processing may advance to a subsequent treatment without performing this purification treatment.

Although the first raw material powder 11 obtained after the above-described process is crystalline silica, an amorphous silica glass powder may be used solely or mixed as the first raw material powder 11 depending on a use application of the silicon container.

A particle size of the first raw material powder 11 is preferably set to 10 to 1000 µm and more preferably set to 50 to 500 µm. Silica (SiO₂) purity of the first raw material powder 11 is preferably set to 99.99% by weight or more, or it is more preferably set to 99.999% by weight or more. In particular, in case of using the finally produced silica container for pulling LSI single-crystal silicon, it is desirable to set the purity of the first raw material powder 11 to 99.999% by weight or more.

When the purity of the first raw material powder 11 is low (poor), to avoid moving or diffusing of impurity metal elements from the produced silica container to the inner surface and to silicon accommodated therein, it is preferable for the first raw material powder 11 to contain predetermined amounts of Al and the OH group. Al can be contained by using a water or alcohol solution of, e.g., a nitrate, an acetate, a carbonate, a chloride, or the like, putting and immersing the silica powder in such a solution, and then performing drying. As for the OH group, the OH group contained in the natural silica stone from the beginning or water to be incorporated in an intermediate step can be controlled by a gas atmosphere, a treatment temperature, and a time in a subsequent drying process.

The details of the mechanism of how these Al and the OH group prevent the impurity metal elements from moving and diffusing in the silica glass is unknown, but it can be considered that Al adsorbs positive ions (cations) of the impurity metal elements and suppresses diffusion of them in order to keep electric charge balance of a silica glass network when Al is replaced by Si. Moreover, it is estimated that the OH group produces the effect of adsorbing the impurity metal elements or preventing diffusion thereof by the replacement of a metal ion with a hydrogen ion.

In addition to the first raw material powder 11 prepared as described above, as shown in (2) of FIG. 3, as a second raw material powder 12, a silica powder which has Ba contained therein at a concentration of 50 to 2000 ppm by mass and has a particle size of 10 to 1000 µm is prepared. The second raw material powder 12 is a raw material powder that forms the innermost surface layer of the silica container 72 according to the present invention. It is to be noted that the second raw material powder 12 can be prepared before a later-described process of forming a second transparent layer.

Like the first raw material powder 11, as a material of the second raw material powder 12, a natural quartz powder or a natural rock crystal powder subjected to a purification treatment, a synthetic cristobalite powder, or a synthetic silica glass powder can be considered. A crystalline silica powder is preferable for the purpose of reducing an amount of gaseous bubbles in the transparent layer, or a synthetic powder is preferable for the purpose of providing the high-purity transparent layer. A particle size is 10 to 1000 µm, or more preferably 100 to 500 µm. As purity, it is preferable to contain 99.9999% by weight or more of a silica (SiO₂) component, 100 ppb by weight or less as a total value of alkali metal elements Li, Na, and K, or more preferably 20 ppb by weight or less of each of alkali metal elements Li, Na, and K, and 10 ppb by weight or less or more preferably 5 ppb by weight or less of each of Ti, V, Cr, Fe, Co, Ni, Cu, Zn, Mo, and W.

Although a method for adding Ba into the second raw material powder 12 is not restricted in particular, the silica powder can be immersed in a Ba compound solution and dried. Specifically, the second raw material powder 12 containing Ba can be obtained by selecting a chloride, an acetate, a nitrate, a carbonate, or the like of Ba, preparing a water or alcohol solution of this compound, immersing the silica powder in this solution, and the effecting drying at 100 to 300°C. It is to be noted that, for recrystallization of silica glass, besides Ba, second group calcium (Ca) or strontium (Sr) is also effective, but Ba, which is preferable from a viewpoint of segregation coefficient (Ba is apt to remain in the silicon melt) of the single-crystal silicon and the silicon melt, is used in the present invention.

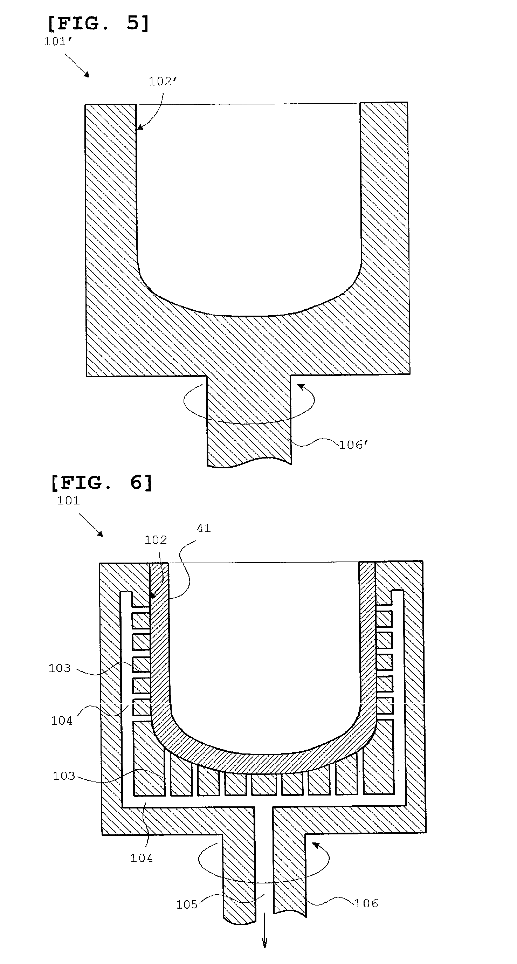

After at least the first raw material powder 11 is prepared, as shown in (3) of FIG. 3, the first raw material powder 11 is then put into a mold having rotational symmetry, and it is temporarily molded into a predetermined shape associated with an inner wall of the mold while rotating the mold, thereby obtaining a temporary compact 41. Each of FIG. 4 and FIG. 5 is a cross-sectional view showing an outline of the mold used for temporarily molding the first raw material powder 11. A mold 101 (FIG. 4) or 101' (FIG. 5) used in the present invention is constituted of a member made of heat resistant ceramics such as graphite, alumina, silicon carbide, silicon nitride and has rotational symmetry, and it can be rotated by using a mold rotating motor (not shown). Moreover, as shown in FIG. 4, pressure-reducing holes 103 may be distributed and formed in an inner wall 102 of the mold 101. The pressure-reducing holes 103 are continuous with a pressure-reducing path 104. Additionally, a pressure-reducing path 105 also runs through a rotary shaft 106 configured to rotate the mold 101, and vacuum drawing can be carried out from this path. In the present invention, it is possible to use such a mold 101' as shown in FIG. 5 which does not have a pressure-reducing equipment. Pressure-reducing holes are not formed in the inner wall 102' of this mold 101', and a pressure-reducing path is not formed in the rotary shaft 106 either. Although a case where the mold 101 shown in FIG. 4 is used will be described, the mold 101' shown in FIG. 5 can be likewise used except that a pressure is not reduced.

In the process shown (3) of FIG. 3, the first raw material powder 11 is introduced to the inner wall 102 of the mold 101 shown in FIG. 4, and the first raw material powder 11 is temporarily molded into a predetermined shape associated with the inner wall 102 of the mold 101, thus obtaining a temporary compact 41 (see FIG. 6). Specifically, the first raw material powder 11 is gradually put to the inner wall 102 of the mold 101 while rotating the mold 101, and it is molded into a container shape by utilizing centrifugal force. Further, a tabular inner mold (not shown) is brought into contact with the rotating powder body from the inner side, whereby a thickness of the temporary compact 41 may be adjusted to a predetermined amount. Furthermore, although a method for supplying this first raw material 11 to the mold 101 is not restricted in particular, for example, a hopper comprising an agitating screw and a measuring feeder may be used. In this case, the first raw material 11 that has filled the hopper is agitated by using the agitating screw, and it is supplied while adjusting a supply mount by using the measuring feeder.

Then, as shown in (4) of FIG. 3, the mold 101 is rotated, and the temporary compact 41 is heated and molten by a discharge heating melting method while rotating the temporary compact 41 in the mold 101. This process enables providing a silica substrate 42 having the first transparent layer made of transparent silica glass in the inner side and the opaque layer that contains gaseous bubbles and is made of opaque silica glass in the outer side.

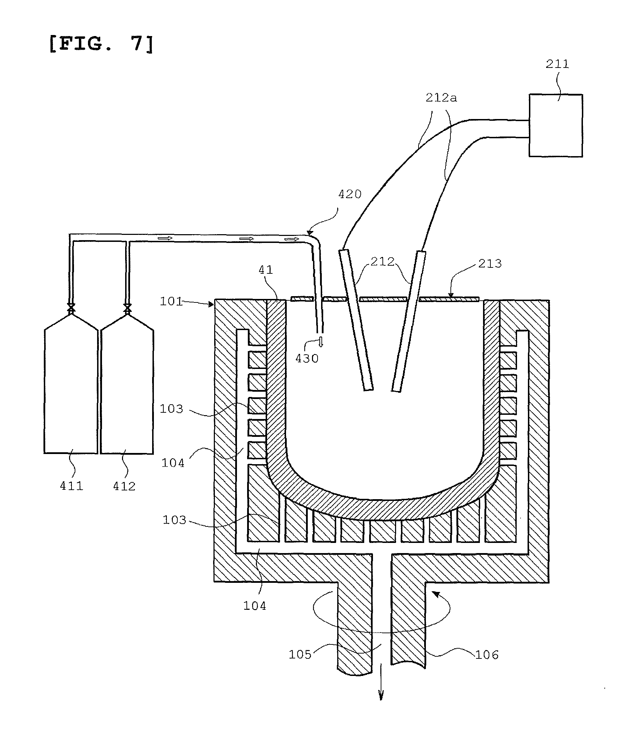

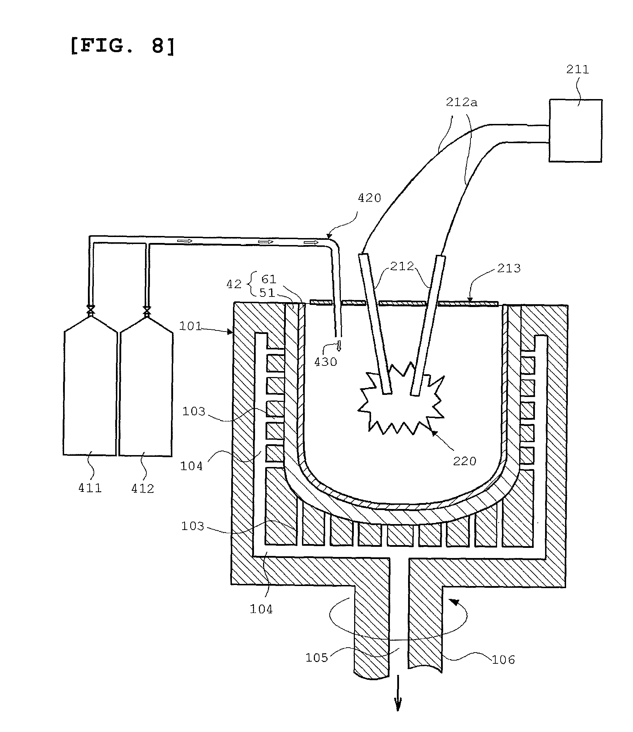

FIG. 7 and FIG. 8 specifically show how this process is performed. An apparatus configured to fabricate this silica substrate 42 comprises the rotatable mold 101 having the rotational symmetry, a degassing vacuum pump, a rotary motor (not shown) that rotates the mold 101, carbon electrodes 212 that can function as a heat source of discharge heating melting (which is also referred to as arc melting or arc discharge melting), electric wires 212a, a high-voltage power supply unit 211, a lid 213, and others. It is to be noted that the number of the carbon electrodes 212 can be two or three, and they can be used with either a direct-current voltage or an alternating-current voltage. The voltage can be adjusted in the range of 100 to 1000 V, and electric energy can be adjusted in the range of 1000 to 3000 kWh. Moreover, this apparatus may also comprise constituent members configured to adjust an atmospheric gas supplied from the inner side of the temporary compact 41, e.g., a hydrogen gas supply cylinder 411, an inert gas supply cylinder 412, a mixed gas supply tube 420, and others.

It is to be noted that this apparatus can be continuously used in a later-described process of forming the second transparent layer.

As a heating, melting and sintering procedure of the temporary compact 41, before starting application of a voltage between the carbon electrodes 212, it is preferable to start supplying a hydrogen containing gas from the inner side of the temporary compact 41. Specifically, as shown in FIG. 7, a hydrogen gas is supplied from the hydrogen gas supply cylinder 411, an inert gas (e.g., nitrogen (N₂), argon (Ar), or helium (He)) is supplied from the inert gas supply cylinder 412, these gases are mixed, and a mixture is supplied from the inner side of the temporary compact 41 through the gas supply tube 420. It is to be noted that each outline arrow indicated by reference numeral 430 represents a flow of the gas. However, such atmospheric gas adjustment does not have to be carried out.

Then, if the atmospheric gas adjustment is carried out, in a state that supply of the mixed gas is continued, the mold having the temporary compact 41 therein is rotated at a fixed rate, and application of a voltage between the carbon electrodes 212 is started. At this time, it is preferable to activate the degassing vacuum pump, start depressurization from the outer side of the temporary compact 41 via the pressure-reducing holes 103 and the pressure-reducing paths 104 and 105, and start application of a voltage between the carbon electrodes 212, but this vacuum drawing (degassing) is not necessary an essential condition. When the heating melting process of the temporary compact 41 is performed while effecting depressurization, thicknesses and others of the opaque layer and the first transparent layer can be more precisely controlled, thereby fabricating the silica substrate 42. When arc discharge (denoted by reference numeral 220 in FIG. 8) begins between the carbon electrodes 212, a melting temperature region (which is assumed to be approximately 1800 to 2000°C) of the silica powder is formed in the inner surface portion of the temporary compact 41, and melting starts from the outermost surface layer portion of the temporary compact 41. In a case where the vacuum drawing is effected, when the outermost surface portion of the temporary compact 41 is molten, a depressurization degree of the vacuum drawing effected by the degassing vacuum pump increases (a pressure is precipitously lowered), and a change into a molten silica glass layer advances from the inner side toward the outer side while releasing water or a dissolved gas such as oxygen or nitrogen contained in the first raw material powder 11 constituting the temporary compact 41. Further, timing for strength adjustment of the vacuum drawing is important, and it is not preferable to perform the strong vacuum drawing before the inner surface layer of the temporary compact 41 is vitrificated. A reason given for this is that, if the strong vacuum drawing is carried out from the beginning, impurity fine particles contained in the atmospheric gas adhere to and concentrate (condense) on the inner surface portion of the temporary compact 41 by the filter effect. Therefore, it is preferable to prevent the depressurization degree from considerably increasing at the beginning and to gradually strengthen the vacuum drawing as the inner surface of the temporary compact 41 is turned to molten glass.

Furthermore, heating based on application of the voltage is continued until approximately inner 1/3 to 1/2 of the total thickness of the temporary compact 41 is molten and turned to transparent or translucent silica glass and approximately remaining outer half of the same is turned to the sintered opaque silica. Through this process, the silica substrate 42 having the opaque layer 51 and the first transparent layer 61 can be produced (see FIG. 8).

As the atmospheric gas in the temporary compact 41 during the discharge heating melting process, air or an inert gas can be used depending on a use application of the silica container to be produced, but the OH group concentration in the opaque layer can be adjusted when the hydrogen containing inert gas atmosphere is provided as described above. It is preferable to maintain water vapor content in the supply gas in this process at a low value, and a dew point temperature of the supply gas may be control to be within ±2°C of a set value in the range of 15°C to -15°C for the purpose of adjusting the OH group content and the water vapor (H₂O) content in the molten and sintered silica substrate. As a control method, the gas can be supplied through an appropriate dehumidifier apparatus.

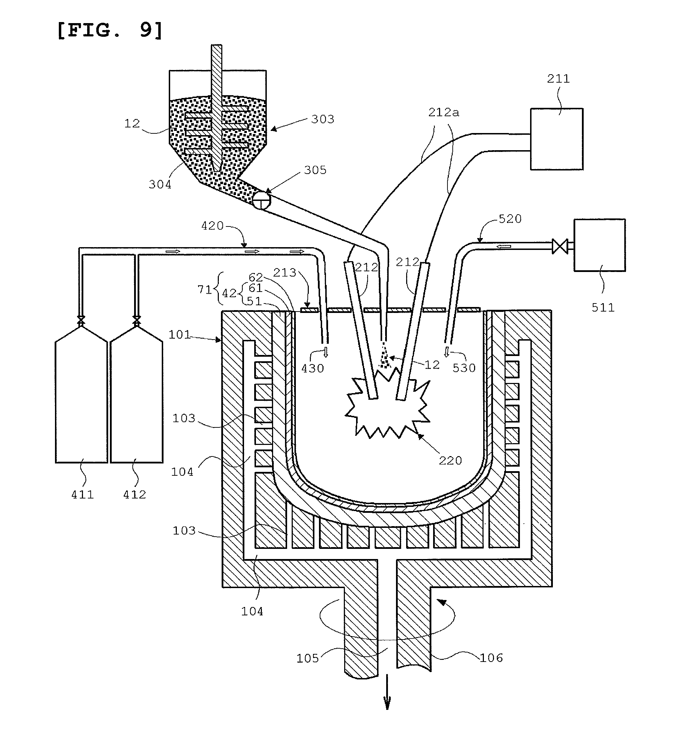

Then, as shown in FIG. 3(5) and FIG. 9, the water vapor containing gas atmosphere is provided in the silica substrate 42, the second raw material powder 12 is spread in the silica substrate 42, and heating and melting are performed based on the discharge heating melting method. As a result, a second transparent layer 62 made of transparent silica glass that contains Ba and the OH group at higher concentration than the first transparent layer is formed on the first transparent layer 61. This process enables fabricating a silica container 71 having the transparent layer constituted of the first transparent layer 61 and the second transparent layer 62 in the inner side and the opaque layer 51 in the outer side.

An apparatus shown in FIG. 9 configured to form the second transparent layer 62 on the inner surface portion of the silica substrate 42 is substantially equal to that in the previous process and comprises a rotatable mold 101 which has rotary shaft symmetry and has the silica substrate 42 (the silica substrate 42 is constituted of the opaque layer 51 and the first transparent layer 61) placed therein, a rotary motor (not shown), a raw material powder hopper 303 having the second raw material powder 12 therein, an agitating screw 304, a measuring feeder 305, carbon electrodes 212 serving as a heat source of the discharge heating melting, electric wires 212a, a high-voltage power supply unit 211, a lid 213, and others. Further, to supply water vapor to the atmosphere at the time of melting, it comprises a water vapor supply apparatus 511, a water vapor supply tube 520, and others. It is to be noted that providing the water vapor containing gas atmosphere in the silica substrate 42 can suffice in this process, and a water vapor supply system can solely present as shown in FIG. 9 but, for example, the water vapor supply system may be coupled with the gas supply tube 420. Moreover, in case of adjusting an atmospheric gas other than water vapor, like the previous process, the hydrogen gas supply cylinder 411, the inert gas supply cylinder 412, the mixed gas supply tube 420, and others may be provided.

As a method for forming the second transparent layer 62, first, the mold 101 is set to a predetermined revolving rate, a high voltage is gradually applied from the high-voltage power supply unit 211 and, at the same time, the second raw material powder 12 is gradually spread from the upper side of the silica substrate 42 by using the raw material hopper 303. At this time, discharge between the carbon electrodes 212 has been already started, a melting temperature region (which is considered to be approximately 1800 to 2000°C) of the silica powder is formed in the silica substrate 42, and hence the spread second raw material powder 12 adheres to the inner surface of the silica substrate 42 (i.e., the inner surface of the first transparent layer 61) as molten particles of silica. The carbon electrodes 211, a raw material powder input opening, and the lid 213 disposed at an upper opening portion of the silica substrate 42 are mechanisms whose positions can be changed with respect to the silica substrate 42 to some extent, and changing these positions enables forming the second transparent layer 62 containing Ba with a uniform thickness on the entire inner surface of the silica substrate 42.

The atmospheric gas in the silica substrate 42 during process is a water vapor containing gas atmosphere. The water vapor can be supplied through the water vapor supply apparatus 511, the water vapor supply tube 520, and others. An arrow denoted by reference numeral 530 in FIG. 9 represents a flow of the water vapor. Additionally, besides the water vapor, a mixed gas with an inert gas such as nitrogen gas (N₂), helium gas (He), or argon gas (Ar) or a mixed gas with air can be used. In particular, He is particularly effective for the purpose of reducing gaseous bubbles in the transparent silica glass layer.

A water vapor introducing technique and water vapor amount control are carried out as follows, for example. First, the inside of the silica substrate 42 is replaced with a nitrogen gas atmosphere, and 100°C saturated water vapor having theoretical density of 0.598 (g/l) is introduced into the silica substrate 42, thereby providing the water vapor containing nitrogen gas atmosphere. In case of increasing a water vapor amount to be introduced, for example, 120°C saturated water vapor having theoretical density of 1.123 (g/l) is introduced into the silica substrate 42, thereby providing the water vapor containing nitrogen gas atmosphere.

Then, as shown in (6) of FIG. 3, the formed silica container 71 is cooled to a room temperature. This cooling process can be carried out in the air atmosphere, but it is preferable to maintain the water vapor containing gas atmosphere in the silica container 71 until a temperature is reduced to at least 200°C or less. A water vapor amount can be adjusted by using the water vapor supply apparatus 511, the water vapor supply tube 520, and others shown in FIG. 9. In this manner, when the water vapor containing gas atmosphere is used as the atmosphere in the cooling process, a fluctuation in OH group concentration during the cooling process can be controlled. In particular, during the cooling process, the OH group concentration can be prevented from being lowered.

The above-described process enables setting the OH group concentration to 200 to 2000 ppm by mass in the region on at least the inner surface side of the second transparent layer 62 and producing the silica container 72 shown in FIG. 1 at low cost.

### [Preliminary Experiment]

To preliminarily examine an influence of the OH group concentration and the Ba concentration in regard to recrystallization of the silica glass surface, the following experiment was conducted.

Based on an oxyhydrogen flame hydrolysis method using silicon tetrachloride (SiCl₄) as a raw material, each synthetic silica glass containing 0, 60, 100, 300, 1000, or 1500 ppm by mass of the OH group was prepared. Then, each synthetic silica glass was pulverized and sized 50 to 500 µm, immersed in a barium nitrate alcohol solution having each concentration, and then dried.

These types of powder silica glass were heated and molten in a clean vacuum electric furnace, and silica glass blocks having various compositions with less gaseous bubbles were thereby obtained. A tabular double-side mirror-polished sample having a dimension of 50 x 50 and a thickness of 30 mm was prepared from each silica glass block. Then, each silica glass sample was set in a clean electric furnace having an air atmosphere therein, a temperature was increased from a room temperature to 1500°C in two hours, each sample was held at 1500°C for one hour, then a power supply was turned off, and cooling was performed. A white recrystallized state of a surface of each sample was visually observed. Table 1 shows its result.

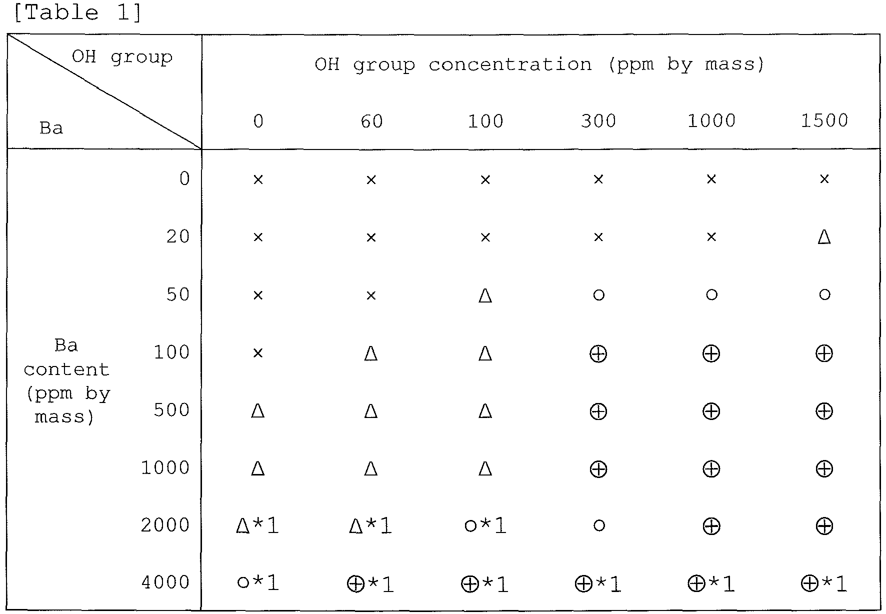

The meaning of each symbol in Table 1 is as follows.
× A colorless and transparent state was remained without recrystallization.
Δ A white translucent state with slight crystallization was obtained.
o Although slight unevenness is present, a white opaque state with an entirely recrystallized surface was obtained.
⊕ A perfect white opaque state with an evenly recrystallized entire surface was obtained.
*1 A state that crystalline silica particles on the surface are apt be delaminated was obtained.

It can be understood from the result of the preliminary experiment shown in Table 1 that, in order to recrystallize a surface of a transparent silica glass body at a high temperature (1500°C in the preliminary experiment), both the OH group and Ba must be contained, the OH group must have a concentration of approximately 200 to 2000 ppm by mass, and Ba must have a concentration of approximately 50 to 2000 ppm by mass.

### EXAMPLES

The present invention will now be more specifically explained hereinafter based on examples and comparative examples, but the present invention is not restricted thereto.

### (Example 1)

In accordance with the steps (1) to (6) shown in FIG. 3, a single-crystal silicon pulling silica container was produced. First, as a first raw material powder 11, a natural quartz powder having a particle size of 50 to 500 µm and purity of 99.999% by weight was prepared. Further, as a second raw material powder 12, a material was prepared by using a natural quartz powder, which is the same as the first raw material powder 11, as a raw material base powder, immersing it in an aqueous solution of barium nitrate, and drying it so that it can contain 200 ppm by mass of Ba.

Subsequently, a graphite mold 101 shown in FIG. 4 and FIG. 6 was rotated, the first raw material powder 11 was put into this mold, thereby obtaining a temporary compact 41. Then, an apparatus shown in FIG. 7 and FIG. 8 was used, a dried mixed gas containing 4% by volume of H₂ and 96% by volume of N₂ was adopted as an atmosphere in the temporary compact 41, air suction and depressurization were performed from an outer peripheral portion, and discharge heating melting was carried out in the temporary compact 41. As a result, a silica substrate 42 having a white opaque silica sintered body (an opaque layer 51) in the outer side and a colorless and transparent silica glass body (a first transparent layer 61) in the inner side was formed. Subsequently, an apparatus shown in FIG. 9 was used, a water vapor containing nitrogen gas was adopted as an atmosphere, the second raw material powder was spread from the upper side of the silica substrate 42, and discharge heating was carried out to form a second transparent layer 62, thus producing a silica container 71.

Then, the water vapor containing gas atmosphere was maintained until a temperature becomes 200°C or less, and the silica container 71 was cooled to a room temperature, whereby the silica container 72 (see FIG. 1) according to the present invention was produced.

### (Example 2)

A silica container was produced like Example 1 except that the concentration of Ba contained in the second raw material powder 12 was changed to 1000 ppm by mass.

### (Example 3)

A silica container was produced like Example 1 except that the concentration of Ba contained in the second raw material powder 12 was changed to 55 ppm by mass and the concentration of the OH group in the second transparent layer 62 was adjusted so as to become 250 ppm by mass.

### (Example 4)

A silica container was produced like Example 1 except that the concentration of Ba contained in the second raw material powder 12 was changed to 55 ppm by mass and the concentration of the OH group in the second transparent layer 62 was adjusted so as to become 1200 ppm by mass.

### (Example 5)

A silica container was produced like Example 1 except that the concentration of Ba contained in the second raw material powder 12 was changed to 110 ppm by mass and the concentration of the OH group in the second transparent layer 62 was adjusted so as to become 200 ppm by mass.

### (Example 6)

A silica container was produced like Example 1 except that the concentration of Ba contained in the second raw material powder 12 was changed to 110 ppm by mass and the concentration of the OH group in the second transparent layer 62 was adjusted so as to become 330 ppm by mass.

### (Example 7)

Conditions were changed from those in Example 1, and a silica container was produced. The concentration of Ba contained in the second raw material powder 12 was changed to 110 ppm by mass. A thickness at the time of forming the temporary compact 41 was increased, a long melting time for the temporary compact 41 was set, and the first transparent layer 61 was formed with a large thickness (4.7 mm). A dried mixed gas containing 10% by volume of H₂ and 90% by volume of N₂ was adopted as an atmosphere of discharge heating melting performed in the temporary compact 41 while reducing a pressure. The concentration of the OH group in the second transparent layer 62 was adjusted so as to become 310 ppm by mass. A total thickness of the first transparent layer 61 and the second transparent layer 62 was adjusted to 6 mm so that the entire transparent layer 52 can have a relatively large thickness.

### (Example 8)

Conditions were changed from those in Example 1 as follows, and a silica container was produced. First, discharge heating melting was performed in the temporary compact 41 at a normal pressure. Consequently, as compared with Example 1, a thickness of the first transparent layer 61 was reduced (1.1 mm), and the OH group concentration in each of the opaque layer 51 and the first transparent layer 61 of the silica substrate 42 was increased. Moreover, the concentration of the OH group in the second transparent layer 62 was adjusted so as to become 420 ppm by mass. A total thickness of the first transparent layer 61 and the second transparent layer 62 was adjusted to 2.2 mm so that a thickness of the entire transparent layer 52 can be relatively small.

### (Comparative Example 1)

A silica substrate was fabricated from the same raw material powder as the first raw material powder used in Example 1 by a reduced-pressure arc melting method (an air atmosphere) which is a conventional method, and this was determined as a silica container (the outer side is a white opaque silica sintered body, and the inner side is a colorless and transparent silica glass body). A raw material powder corresponding to the second raw material powder in Example 1 was not used.

### (Comparative Example 2)

A silica container was produced by a normal-pressure arc melting method and a powdery raw material spreading arc melting method as conventional methods. That is, first, a temporary compact was formed from the same raw material powder as the first raw material powder in Example 1, and a silica substrate constituted of a white opaque silica glass layer in the outer side and a white translucent silica glass layer in the inner side was fabricated by the normal-pressure arc melting method. A synthetic cristobalite powder (particle size: 50 to 300 µm, purity: 99.9999% by weight) was spread on the inner side of this silica substrate, and melting was effected, whereby a transparent silica glass layer was formed.

### (Comparative Example 3)

Although a silica container was produced basically in the same manner as Example 1, the following points were changed. Air was used as an atmosphere at the time of heating and melting a temporary compact. Additionally, although Ba was contained in the second raw material powder at a concentration of 500 ppm by mass, air from which water vapor was removed was used as an atmosphere in a second transparent layer forming process.

### (Comparative Example 4)

A silica container was produced like Example 2 except that Ba was not added to the second raw material powder.

### [Evaluation Method in Examples and Comparative Examples]

Physical properties and characteristics of each raw material powder used and the silica container produced in each of the examples and the comparative examples were evaluated as follows.

### Method for Measuring Particle Size of each Raw Material Powder:

Observation of a two-dimensional shape and measurement of an area of each raw material powder were carried out with use of an optical microscope or an electron microscope. Then, a shape of each particle was assumed to be a perfect circle, and a diameter was calculated from an area measured value. This technique was statistically repeatedly carried out, and the obtained values are listed in Tables 2 to 7 as the values in the particle size range (99% by weight or more of the raw material powder is included in this range).

### Measurement of Layer Thickness of Silica Container:

Each silica container was cut by a cutter, and a cross section of the silica container at a central part of a total sidewall height was measured with use of a scale, thereby obtaining a thickness of each layer.

### Measurement of the OH Group Concentration:

A glass sample obtained from each of the opaque layer portion and the transparent layer portion was cut and prepared, and the OH group concentration was measured by infrared absorption spectrophotometry. However, in regard to a transparent layer inner surface portion, two points at a depth of 0.5 mm and a depth of 1.0 mm from a silica container inner surface were measured, and an arithmetic mean value was shown. Additionally, in regard to a transparent layer deep portion, two points at a depth of 1.5 mm and a depth of 2.0 mm were measured, and an arithmetic mean value was shown.

Conversion from the infrared absorption to the OH group concentration is based on the following reference.

Dodd, D. M. and Fraser, D. B. (1966) Optical determination of OH in fused silica. Journal of Applied Physics, vol. 37, P. 3911.

### Analysis of Al Concentration and Ba Concentration:

Respective flake-like samples were obtained from a portion from the inner surface of the silica container to a depth of 1 mm and from a portion from a depth of 1.5 mm to a depth of 2.5 mm, solutions thereof were prepared by an acid treatment, and concentration analysis was conducted. The concentration analysis was conducted based on plasma atomic emission spectrometry (ICP-AES), plasma mass spectrometry (ICP-MS), or atomic absorption spectrophotometry (AAS).

### Evaluation of Continuous Pulling (Multi-pulling) of Single-crystal Silicon:

Metallurgical grade polysilicon having a purity of 99.9999999% by weight was put into the produced silica container, a temperature was increased to obtain silicon melt, then pulling of single-crystal silicon was repeatedly performed for three times (multi-pulling), and a success rate of single-crystal growth was evaluated. As pulling conditions, an argon (Ar) gas 100% atmosphere was provided in a pulling apparatus (a CZ apparatus), a pulling rate was 0.6 mm/minute, a single-crystal silicon dimension was set to a diameter of 300 mm and a length of 600 mm, and an operating time of one batch was set to approximately 80 hours. Success ratios of repetition of the single-crystal growth for three times were classified as follows.

| | |
|---|---|
| Succeeded three times | ○ (good) |
| Succeeded twice | Δ (slightly poor) |
| Succeeded once | × (poor) |

### Evaluation of Voids, Pinholes, and Foreign Particles in Single-crystal Silicon:

In the single-crystal silicon continuous pulling, 200 silicon wafers, each of which has a diameter of 300 mm and a thickness of 200 µm and was subjected to double-side polishing, were produced from an arbitrary region of the first single crystal silicon after the multi-pulling of each single crystal silicon. Then, the number of voids, pinholes, and foreign particles present on both sides of each silicon wafer were measured by using a particle detector, a numerical treatment was statistically carried out, and the number of defect-free silicon wafers in 200 silicon wafers were obtained. As a result, the following evaluations were provided in accordance with the numbers of silicon wafers from which voids, pinholes, and foreign particles were not detected.

The number of defect-free silicon wafers:
200 to 199 ○ (good)

The number of defect-free silicon wafers:
198 to 197 Δ (slightly poor)

The number of defect-free silicon wafers:
196 or less × (poor)

### Evaluation of Etching Resistance of Silica Container:

After end of the evaluation of the single-crystal silicon continuous pulling, each sample having a dimension of 200 mm × 50 mm × a sidewall total thickness were cut out from a portion of each silica container near the upper part of the initial silicon melt surface (a portion that is not in contact with the silicon melt) over the total thickness of the silica container sidewall. Then, an evaluation test silica glass container having a crucible shape was additionally prepared, the prepared evaluation test silica glass container was filled with polycrystalline silicon, and melting was effected with use of an electric furnace to obtain silicon melt. A half of a lower portion of each sample was immersed in the silicon melt. In this state, 1500°C was maintained in the electric furnace for 80 hours, and then each sample was pulled. Subsequently, an etching amount of a surface of each sample on a side which was a silica container inner surface side before cutting was obtained by measuring a cross-sectional thickness by using a scale.

Etched thickness:
less than 1.5 mm ○ (good)

Etched thickness:
1.5 mm to less than 3 mm Δ (slightly poor)

Etched thickness:
3 mm or more × (poor)

The producing conditions, the measured physical properties, and the evaluation results of the respective silica containers produced in Examples 1 to 8 and Comparative Examples 1 to 4 are collectively shown in the following Tables 2 to 7.

**[Table 2]**

| Example number | | Example 1 | Example 2 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | Raw material base powder | Natural quartz powder particle size: 50 to 500 µm purity: 99.999% by weight | Natural quartz powder particle size: 50 to 500 µm purity: 99.999% by weight |
| | Ba concentration (ppm by mass) | 200 | 1000 |
| | Heating drying treatment atmosphere, temperature, time | Air, 200°C, 50 hours | Air, 200°C, 50 hours |
| First raw material powder temporary molding method | | Rotational molding in mold | Rotational molding in mold |
| Temporary compact melting and sintering method | | Reduced-pressure arc discharge heating | Reduced-pressure arc discharge heating |
| Temporary compact melting and sintering atmosphere | | H₂: 4% by volume, N₂: 96% by volume | H₂: 4% by volume, N₂: 96% by volume |
| Second raw material powder melting method | | Powder spreading normal-pressure arc discharge heating | Powder spreading normal-pressure arc discharge heating |
| Second raw material powder melting atmosphere | | Water vapor containing nitrogen gas | Water vapor containing nitrogen gas |
| Physical properties of opaque layer | Outer diameter, height, thickness (mm) | Outer diameter 800, height 360, thickness 14 | Outer diameter 800, height 360, thickness 14 |
| | Color tone | White opaque | White opaque |
| | OH group concentration (ppm by mass) | 30 | 30 |
| Physical properties of transparent layer | Thickness (mm) | 3 | 3 |
| | Color tone | Colorless and transparent | Colorless and transparent |
| Physical properties of deep portion in transparent layer | OH group concentration (ppm by mass) | 35 | 35 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 890 | 830 |
| | Al concentration (ppm by mass) | 2 | 2 |
| | Ba concentration (ppm by mass) | 190 | 960 |
| Evaluation | Single-crystal multi-pulling | ○ | ○ |
| | Voids, pinholes, foreign particles in single crystal | ○ | ○ |
| | Etching resistance of container | ○ | ○ |

**[Table 3]**

| Example number | | Example 3 | Example 4 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | raw material base powder | Natural quartz powder particle size: 50 to 500 µm purity: 99.999% by weight | Natural quartz powder particle size: 50 to 500 µm purity: 99.999% by weight |
| | Ba concentration (ppm by mass) | 55 | 55 |
| | Heating drying treatment atmosphere, temperature, time | Air, 200°C, 50 hours | Air, 200°C, 50 hours |
| First raw material powder temporary molding method | | Rotational molding in mold | Rotational molding in mold |
| Temporary compact melting and sintering method | | Reduced-pressure arc discharge heating | Reduced-pressure arc discharge heating |
| Temporary compact melting and sintering atmosphere | | H₂: 4% by volume, N₂: 96% by volume | H₂: 4% by volume, N₂: 96% by volume |
| Second raw material powder melting method | | Powder spreading normal-pressure arc discharge heating | Powder spreading normal-pressure arc discharge heating |
| Second raw material powder melting atmosphere | | Water vapor containing nitrogen gas | Water vapor containing nitrogen gas |
| Physical properties of opaque layer | Outer diameter, height, thickness (mm) | Outer diameter 800, height 360, thickness 14 | Outer diameter 800, height 360, thickness 14 |
| | Color tone | White opaque | White opaque |
| | OH group concentration (ppm by mass) | 30 | 30 |
| Physical properties of transparent layer | Thickness (mm) | 3 | 3 |
| | Color tone | Colorless and transparent | Colorless and transparent |
| Physical properties of deep portion in transparent layer | OH group concentration (ppm by mass) | 35 | 40 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 250 | 1200 |
| | Al concentration (ppm by mass) | 2 | 2 |
| | Ba concentration (ppm by mass) | 50 | 50 |
| Evaluation | Single-crystal multi-pulling | ○ | ○ |
| | Voids, pinholes, foreign particles in single crystal | Δ | ○ |
| | Etching resistance of container | Δ | Δ |

**[Table 4]**

| Example number | | Example 5 | Example 6 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | raw material base powder | Natural quartz powder particle size: 50 to 500 µm purity: 99.999% by weight | Natural quartz powder particle size: 50 to 500 µm purity: 99.999% by weight |
| | Ba concentration (ppm by mass) | 110 | 110 |
| | Heating drying treatment atmosphere, temperature, time | Air, 200°C, 50 hours | Air, 200°C, 50 hours |
| First raw material powder temporary molding method | | Rotational molding in mold | Rotational molding in mold |
| Temporary compact melting and sintering method | | Reduced-pressure arc discharge heating | Reduced-pressure arc discharge heating |
| Temporary compact melting and sintering atmosphere | | H₂: 4% by volume, N₂: 96% by volume | H₂: 4% by volume, N₂: 96% by volume |
| Second raw material powder melting method | | Powder spreading normal-pressure arc discharge heating | Powder spreading normal-pressure arc discharge heating |
| Second raw material powder melting atmosphere | | Water vapor containing nitrogen gas | Water vapor containing nitrogen gas |
| Physical properties of opaque layer | Outer diameter, height, thickness (mm) | Outer diameter 800, height 360, thickness 14 | Outer diameter 800, height 360, thickness 14 |
| | Color tone | White opaque | White opaque |
| | OH group concentration (ppm by mass) | 30 | 30 |
| Physical properties of transparent layer | Thickness (mm) | 3 | 3 |
| | Color tone | Colorless and transparent | Colorless and transparent |
| Physical properties of deep portion in transparent layer | OH group concentration (ppm by mass) | 30 | 35 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 200 | 330 |
| | Al concentration (ppm by mass) | 2 | 2 |
| | Ba concentration (ppm by mass) | 100 | 100 |
| Evaluation | Single-crystal multi-pulling | ○ | ○ |
| | Voids, pinholes, foreign particles of single crystal | ○ | ○ |
| | Etching resistance of container | Δ | ○ |

**[Table 5]**

| Example number | | Example 7 | Example 8 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | raw material base powder | Natural quartz powder particle size: 50 to 500 µm purity: 99.999% by weight | Natural quartz powder particle size: 50 to 500 µm purity: 99.999% by weight |
| | Ba concentration (ppm by mass) | 110 | 200 |
| | Heating drying treatment atmosphere, temperature, time | Air, 200°C, 50 hours | Air, 200°C, 50 hours |
| First raw material powder temporary molding method | | Rotational molding in mold | Rotational molding in mold |
| Temporary compact melting and sintering method | | Reduced-pressure arc discharge heating | Normal-pressure arc discharge heating |
| Temporary compact melting and sintering atmosphere | | H₂: 10% by volume, N₂: 90% by volume | H₂: 4% by volume, N₂: 96% by volume |
| Second raw material powder melting method | | Powder spreading normal-pressure arc discharge heating | Powder spreading normal-pressure arc discharge heating |
| Second raw material powder melting atmosphere | | Water vapor containing nitrogen gas | Water vapor containing nitrogen gas |
| Physical properties of opaque layer | Outer diameter, height, thickness (mm) | Outer diameter 800, height 360, thickness 14 | Outer diameter 800, height 360, thickness 14 |
| | Color tone | White opaque | White opaque |
| | OH group concentration (ppm by mass) | 20 | 80 |
| Physical properties of transparent layer | Thickness (mm) | 6 | 2.2 |
| | Color tone | Colorless and transparent | Colorless and transparent |
| Physical properties of deep portion in transparent layer | OH group concentration (ppm by mass) | 10 | 80 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 310 | 420 |
| | Al concentration (ppm by mass) | 2 | 2 |
| | Ba concentration (ppm by mass) | 100 | 180 |
| Evaluation | Single-crystal multi-pulling | ○ | ○ |
| | Voids, pinholes, foreign particles in single crystal | ○ | Δ |
| | Etching resistance of container | ○ | ○ |

**[Table 6]**

| Example number | | Comparative example 1 | Comparative example 2 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | raw material base powder | - | Synthetic cristobalite powder particle size: 50 to 300 µm purity: 99.9999% by weight |
| | Ba concentration (ppm by mass) | - | None |
| | Heating drying treatment atmosphere, temperature, time | - | None |
| First raw material powder temporary molding method | | Rotational molding in mold | Rotational molding in mold |
| Temporary compact melting and sintering method | | Reduced-pressure arc discharge heating | Normal-pressure arc discharge heating |
| Temporary compact melting and sintering atmosphere | | Air | Air |
| Second raw material powder melting method | | - | Powder spreading normal-pressure arc discharge heating |
| Second raw material powder melting atmosphere | | - | Air |
| Physical properties of opaque layer | Outer diameter, height, thickness (mm) | Outer diameter 800, height 360, thickness 15 | Outer diameter 800, height 360, thickness 15 |
| | Color tone | White opaque | White opaque |
| | OH group concentration (ppm by mass) | 60 | 120 |
| Physical properties of transparent layer | Thickness (mm) | 2.5 | 3 |
| | Color tone | Colorless and transparent | Colorless and transparent |
| Physical properties of deep portion in transparent layer | OH group concentration (ppm by mass) | 50 | 100 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 40 | 65 |
| | Al concentration (ppm by mass) | 2 | <1 |
| | Ba concentration (ppm by mass) | 0 | 0 |
| Evaluation | Single-crystal multi-pulling | × | × |
| | Voids, pinholes, foreign particles in single crystal | Δ | Δ |
| | Etching resistance of container | × | × |

**[Table 7]**

| Example number | | Comparative example 3 | Comparative example 4 |
|---|---|---|---|
| First raw material powder | | Natural quartz powder particle size: 50 to 500 µm purity: 99.999% by weight | Natural quartz powder particle size: 50 to 500 µm purity: 99.999% by weight |
| Second raw material powder | raw material base powder | Natural quartz powder particle size: 50 to 500 µm purity: 99.9999% by weight | Natural quartz powder particle size: 50 to 500 µm purity: 99.999% by weight |
| | Ba concentration (ppm by mass) | 500 | None |
| | Heating drying treatment atmosphere, temperature, time | Air, 200°C, 100 hours | None |
| First raw material powder temporary molding method | | Rotational molding in mold | Rotational molding in mold |
| Temporary compact melting and sintering method | | Reduced-pressure arc discharge heating | Reduced-pressure arc discharge heating |
| Temporary compact melting and sintering atmosphere | | Air | H₂: 4% by volume, N₂: 96% by volume |
| Second raw material powder melting method | | Powder spreading normal-pressure arc discharge heating | Powder spreading normal-pressure arc discharge heating |
| Second raw material powder melting atmosphere | | Water vapor removed air | Water vapor containing nitrogen gas |
| Physical properties of opaque layer | Outer diameter, height, thickness (mm) | Outer diameter 800, height 360, thickness 14 | Outer diameter 800, height 360, thickness 14 |
| | Color tone | White opaque | White opaque |
| | OH group concentration (ppm by mass) | 60 | 30 |
| Physical properties of transparent layer | Thickness (mm) | 3 | 3 |
| | Color tone | Colorless and transparent | Colorless and transparent |
| Physical properties of deep portion in transparent layer | OH group concentration (ppm by mass) | 55 | 35 |
| | Al concentration (ppm by mass) | 2 | 2 |
| | Ba concentration (ppm by mass) | 0 | 0 |
| Physical properties of inner surface portion in transparent layer | OH group concentration (ppm by mass) | 35 | 820 |
| | Al concentration (ppm by mass) | 2 | 2 |
| | Ba concentration (ppm by mass) | 480 | 0 |
| Evaluation | Single-crystal multi-pulling | Δ | Δ |
| | Voids, pinholes, foreign particles in single crystal | × | Δ |
| | Etching resistance of container | Δ | × |

As can be understood from Tables 2 to 7, in each of Examples 1 to 8, the etching resistance of the silica container inner surface was successfully enhanced. Further, the continuous pulling of single-crystal silicon was successfully performed with less voids, pinholes, and foreign particles. That is, in a comprehensive manner, each of the silica containers according to Examples 1 to 8 was more excellent for the single-crystal silicon pulling purpose than each of the silica containers according to Comparative Examples 1 to 4.

It is to be noted that the present invention is not restricted to the foregoing embodiment. The foregoing embodiment is just an illustrative example, and any example that has substantially the same configuration and exercises the same functions and effects as the technical concept disclosed in claims according to the present invention is included in the technical scope of the present invention.

## Claims

1. A single-crystal silicon pulling silica container comprising: a transparent layer made of transparent silica glass in an inner side of the silica container, and an opaque layer made of opaque silica glass containing gaseous bubbles in an outer side of the silica container,
wherein the transparent layer is constituted of a high-OH group layer that is placed in an inner surface side of the silica container and contains the OH group at a concentration of 200 to 2000 ppm by mass and a low-OH group layer that has the OH group concentration lower than that of the high-OH group layer, and
the high-OH group layer contains Ba at a concentration of 50 to 2000 ppm by mass.

2. The single-crystal silicon pulling silica container according to claim 1,
wherein a thickness of the high-OH group layer is 0.5 mm or more and 3 mm or less.

3. The single-crystal silicon pulling silica container according to claim 1 or 2,
wherein the high-OH group layer contains Ba at a concentration of 100 to 1000 ppm by mass and contains the OH group at a concentration of 300 to 1500 ppm by mass.

4. A method for producing a single-crystal silicon pulling silica container, comprising the steps of:
preparing a silica powder having a particle size of 10 to 1000 µm as a first raw material powder;
preparing a silica powder that contains Ba at a concentration of 50 to 2000 ppm by mass and has a particle size of 10 to 1000 µm, as a second raw material powder;
putting the first raw material powder into a mold, temporarily molding the first raw material powder into a predetermined shape associated with an inner wall of the mold while rotating the mold, and thereby forming a temporary compact;
heating and melting the temporary compact by a discharge heating melting method while rotating the temporary compact in the mold, and thereby obtaining a silica substrate that comprises a first transparent layer made of transparent silica glass in an inner side of the silica substrate and an opaque layer made of opaque silica glass containing gaseous bubbles in an outer side of the silica substrate;
providing a water vapor containing gas atmosphere on the inner side of the silica substrate, performing heating and melting based on a discharge heating melting method while spreading the second raw material powder on the inner side of the silica substrate, forming on the first transparent layer a second transparent layer made of transparent silica glass containing Ba and the OH group at higher concentrations than those of the first transparent layer, and thereby fabricating a silica container having a transparent layer constituted of the first transparent layer and the second transparent layer in an inner side of the silica container and an opaque layer in an outer side of the silica container; and
cooling the fabricated silica container to a room temperature,
wherein the OH group concentration is 200 to 2000 ppm by mass in a region on at least an inner surface side of the second transparent layer.

5. The method for producing a single-crystal silicon pulling silica container according to claim 4,
wherein, at the step of cooling, the water vapor containing gas atmosphere is provided in the silica container until a temperature is lowered to at least 200°C or less.

6. The method for producing a single-crystal silicon pulling silica container according to claim 4 or 5,
wherein the step of heating and melting the temporary compact is carried out while degassing a gas component contained the temporary compact by reducing a pressure from the outside of the temporary compact.
